# EUROPEAN PATENT APPLICATION

(11) **EP 4 776 837 A1**
(43) Date of publication of application: **15.07.2026**
(21) Application number: 25227722.3
(22) Date of filing: 30.12.2025
(51) Int. Cl.: H10W 70/40, H10W 90/00, H10W 40/77, H10W 70/01, H10W 74/10

(54) **METHOD OF MANUFACTURING SEMICONDUCTOR DEVICES AND CORRESPONDING SEMICONDUCTOR DEVICE**

(30) Priority: 10.01.2025 IT 202500000285
(71) Applicant: STMicroelectronics International N.V., 1228 Plan-les-Ouates, Geneva (CH)
(72) Inventor: CATALANO, Guendalina, I-20125 Milano (IT); GOTTARDI, Thomas, I-20864 Agrate Brianza (Monza Brianza) (IT)
(74) Representative: Buzzi, Notaro & Antonielli d'Oulx S.p.A.

(57) **Abstract**

A semiconductor die (14) is arranged at a die pad (10) of a leadframe (21) comprising an array of electrically conductive leads (12, 22) around the die pad (10). The array including a first (12) and a second (22) set of electrically conductive leads (22).

At least one conductive lead in the first set of electrically conductive leads (22) comprises a base lead portion (22A) co-planar with the die-pad (10) and a raised lead portion (22B), wherein the die pad (10) is arranged at a downset location with respect to said raised lead portion (22B).

The semiconductor die (14) is electrically coupled to leads (12) in the second set of electrically conductive leads (12) via electrically conductive wires (16) extending therebetween.

The semiconductor die (14) is electrically coupled to the at least one conductive lead (22) in the first set of electrically conductive leads (22) by applying onto the semiconductor die (14) and the electrically conductive wires (16) an electrically conductive clip (28) comprising an electrically conductive protrusion (280) electrically coupled to the semiconductor die (14) as well as at least one distal portion (282) electrically coupled to the raised lead portion (22B) of the at least one conductive lead (22) in the first set of electrically conductive leads (22).

## Description

### Technical field

The description relates to semiconductor devices.

One or more embodiments can be applied to power semiconductor devices including integrated circuits (ICs), for instance.

### Background

Power semiconductor devices may be provided with a Dual-Side Cooling (DSC) package that facilitates dissipating heat generated during operation of the device.

DSC power devices comprise one or more semiconductor (Si, SiC or GaN, for instance) dice arranged on a substrate (a leadframe, for instance) and electrically coupled to selected pad or pads in the substrate via an electrically conductive clip. The assembly is embedded in a plastic (electrically insulating), protective package.

Heat generated by the semiconductor die embedded in the package may dissipate via the substrate and the electrically conductive clip that are both exposed at the outer surfaces of the DSC package.

Having both the substrate and the clip exposed at the outer surface of the package may reduce flexibility of the design of the device and its compactness. For instance, providing low power electrical coupling via electrically conductive wires may be made difficult by the volume of the clip provided for power coupling. This may be relevant in so-called System-in-Package devices wherein a power semiconductor die is electrically coupled to a second semiconductor die (a controller or driver, for instance) via electrically conductive wires extending between the two semiconductor dice.

Documents such as US 20080023807 A1, US 20240145340 A1, US 20230079413 A1, US 9620440 B1, CN 108573946 B and US 20230028579 A1 provide background information in the related technological area.

### Object and summary

An object of one or more embodiments is to overcome the drawbacks discussed in the foregoing.

According to one or more embodiments, that object is achieved via a method having the features set forth in the claims that follow.

One or more embodiments also relate to a corresponding semiconductor device.

The claims are an integral part of the technical teaching provided in respect of the embodiments.

Solutions as described herein facilitate providing a design for DSC packages that is flexible and relatively simple to implement.

In solutions as described herein, a semiconductor die is arranged on a substrate comprising electrically conductive leads having a raised portion.

Solutions as described herein involve applying an electrically conductive clip onto a semiconductor die as well as onto electrically conductive wires providing low power electrical coupling to the semiconductor die.

In solutions as described herein the electrically conductive clip is arranged with peripheral portions thereof in electrical contact with the raised portion of the leads.

### Brief description of the figures

One or more embodiments will now be described, by way of example only, with reference to the annexed figures, wherein:
Figure 1 is a perspective view of a semiconductor device to which embodiments of the present description can apply,
Figures 2A to 2E are cross-sectional views illustrative of processing steps according to embodiments of the present description,
Figure 3 is a cross-sectional view of a semiconductor device obtainable via processing steps as described herein,
Figures 4 to 6 are plan views illustrative of certain aspects of semiconductor devices according to possible embodiments of the present description, and
Figures 7 to 8 are cross-sectional views illustrative of further embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

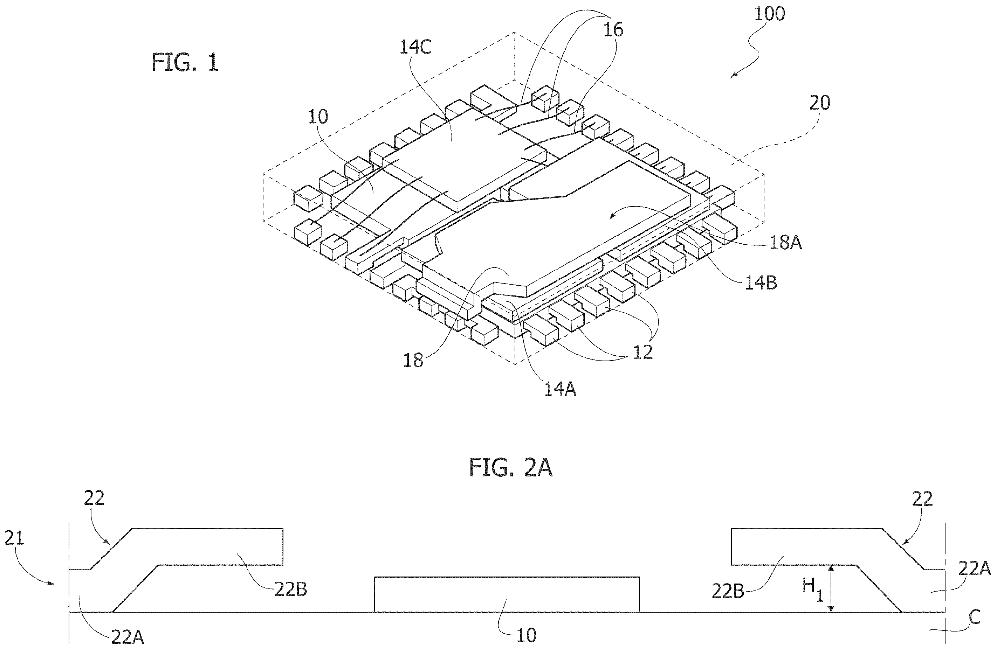

Figure 1 is a perspective view of the structure of a semiconductor device 100 such as a power device for automotive applications, for instance.

The exemplary semiconductor device 100 illustrated in Figure 1 comprises:
a substrate such as a leadframe, for instance, having one or more semiconductor chips or dice 14A, 14B, 14C (the terms chip/chips and die/dice are regarded as synonymous) arranged at respective die pads 10 of the substrate,
electrically conductive formations 16, 18 providing electrical coupling between the semiconductor dice 14A, 14B, 14C and between the semiconductor dice and the leads 12 (outer pads) in the substrate, and
an electrically insulating encapsulation 20 (illustrated as transparent in Figure 1 to illustrate the details of the device 100) molded on the assembly to provide a plastic body to the device 100.

The designation "leadframe" (or "lead frame") is currently used (see, for instance the USPC Consolidated Glossary of the United States Patent and Trademark Office) to indicate a metal frame that provides support for an integrated circuit chip or die (the terms chip/chips and die/dice are herein regarded as synonymous) as well as electrical leads to interconnect the integrated circuit in the die or chip to other electrical components or contacts.

Essentially, a leadframe comprises an array of electrically-conductive formations (or leads) 12 that from an outline location extend inwardly in the direction of a semiconductor die thus forming an array of electrically-conductive formations from a die pad 10 configured to have at least one semiconductor die 14A, 14B, 14C attached thereon. This may be via conventional means such as a die attach adhesive (a die attach film or DAF, for instance).

In a power semiconductor device 100 as exemplified in Figure 1, the current transferred from the high-power section (comprising, for instance, the semiconductor dice 14A and 14B) to the output pads 12 of the device 100 can be significant and clips 18 (or ribbons) are used for that purpose in the place of wires.

As illustrated, wires 16 can still be used to provide electrical coupling to a low-power section in the device 100 (a controller die such as the semiconductor die 14C, for instance).

A device 100 as illustrated in Figure 1 is intended to be mounted on a support such as a printed circuit board, PCB, (not visible in the figures for simplicity), via solder material, for instance.

A structure of a device as discussed so far is conventional in the art, which makes it unnecessary to provide a more detailed description herein.

Power semiconductor devices (a device 100 as exemplified in Figure 1, for instance) may generate a considerable amount of heat during normal operation.

Dissipation of heat (for instance, generated by the power semiconductor dice 14A, 14B) may occur via the die pads 10 of a thermally (and electrically) conductive material such as copper, for instance. Heat may be transferred to the support (a PCB, for instance) of the device via the (thermally conductive) die pad(s) 10.

In so called dual side cooling (DSC) packages, dissipation of heat may occur also via an electrically conductive clip 18 exposed at the front/top surface of the package 20. In DSC packages the electrically conductive clip is thus advantageously used for:
transferring current from the high-power sector of the device to (power) leads 12 in the substrate, and
dissipating heat generated by the power semiconductor die 14A, 14B.

As mentioned, in a device 100 as exemplified in Figure 1, the semiconductor dice 14A, 14B are electrically coupled to (power) leads 12 via the electrically conductive clip 18. Furthermore, the semiconductor dice 14A, 14B are electrically coupled to (low-power) leads 12 and/or to a further semiconductor die 14C (a controller die, for instance) via electrically conductive wires 16.

Providing the desired electrical coupling between the semiconductor dice 14A, 14B, 14C and between the semiconductor dice 14A, 14B, 14C and the leads 12 may undesirably pose constraints on the design of the device 100.

For instance, in order to make room for electrically conductive wires 16 landing at the front/top surface of the power semiconductor die 14B (at die bonding pads or electrical contacts provided thereon) the electrically conductive clip 18 may have a cut-out portion that undesirably reduces the area of the exposed surface of the electrically conductive clip 18.

Solutions as described herein facilitate providing a design for DSC packages that is flexible and relatively simple to implement.

In solutions as described herein, a semiconductor die is arranged on a substrate comprising electrically conductive leads having a raised portion.

Solutions as described herein involve applying an electrically conductive clip onto a semiconductor die as well as onto electrically conductive wires providing low-power electrical coupling to the semiconductor die. Electrically conductive wires may extend below the electrically conductive clip applied onto the semiconductor die.

Figures 2A to 2E are cross-sectional views illustrative of a sequence of processing steps according to embodiments of the present description.

It will be otherwise appreciated that the sequence of steps of Figures 2A to 2E is merely exemplary insofar as:
one or more steps illustrated in Figures 2A to 2E can be omitted, performed in a different manner (with other tools, for instance) and/or replaced by other steps;
additional steps may be added;
one or more steps can be carried out in a sequence different from the sequence illustrated.

Figure 2A is illustrative of a leadframe 21 according to embodiments of the present description arranged on a temporary (and possibly sacrificial) carrier C.

As illustrated, the leadframe 21 comprises (at least) one die pad 10 configured to have a semiconductor die attached thereon, and an array of electrically conductive leads 22 around the die pad 10.

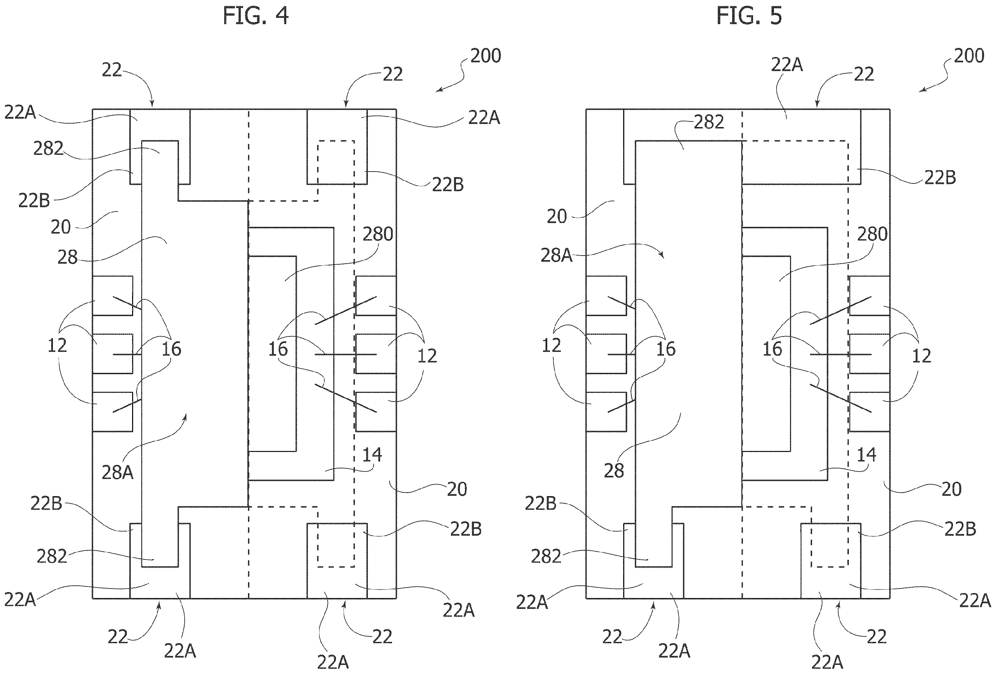

The array of electrically conductive leads 22 may comprise:
a first set of (high-power) leads 22 configured to provide power input/output terminals to the semiconductor device, and
a second set of (low-power) leads (visible in Figures 4 to 6, for instance, and referenced therein with the reference 12) configured to provide low-power input/output terminals (control terminals, for instance) to the semiconductor device.

In one or more embodiments, the first set of leads 22 may comprise at least one lead having an "S"-like shape, with a base portion 22A at the same level of the die pad 10 and a raised portion 22B, raised with respect to the base portion 22A of the leads 22 (and with respect to the die pad 10).

That is, at least one lead 22 in the first set of (high-power) leads comprises a base lead portion 22A and a raised lead portion 22B, wherein the base lead portion 22A and the die pad 10 comprise leadframe material (copper, for instance) in a first plane and the raised lead portion 22B of the leads comprises leadframe material in a second plane parallel to the first plane (and at a distance H1 therefrom).

In one or more embodiments, both the (high-power) leads 22 in the first set and the (low-power) leads 12 in the second set have an "S"-like shape as exemplified in the figures.

Said otherwise, at least one conductive lead 22 in the first set of electrically conductive leads 22 comprises a base lead portion 22A co-planar with the die-pad 10 and a raised lead portion 22B. The die pad 10 is arranged at a downset location with respect to the raised lead portion 22B.

In the embodiments illustrated in Figure 2A, the leads 22 are arranged with the raised lead portion 22B facing the die pad 10.

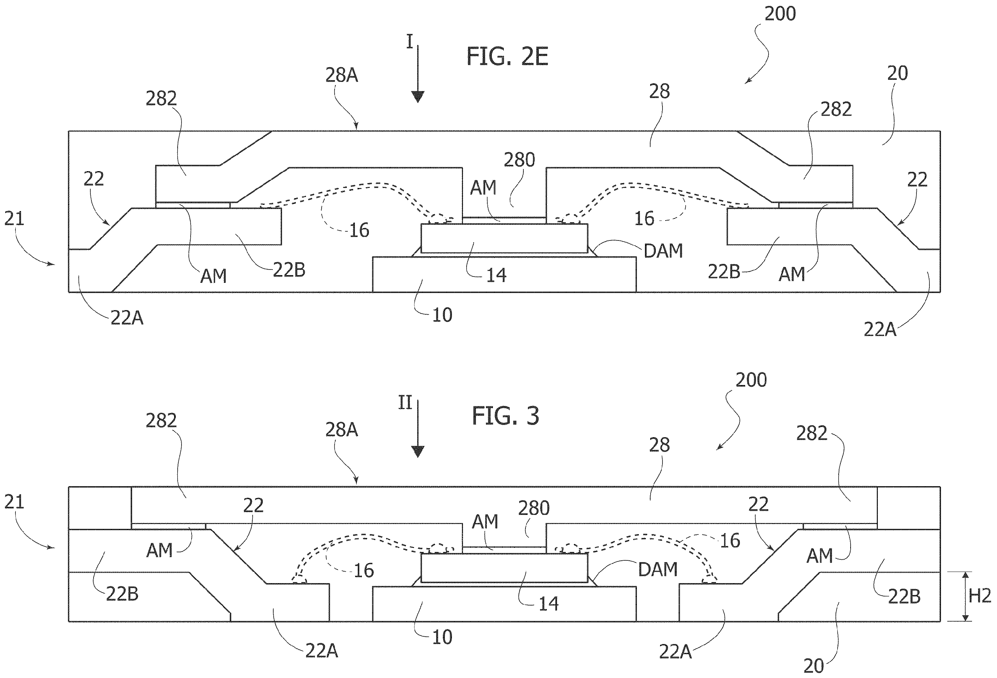

In one or more embodiments, the leads 22 may be arranged with the raised lead portion 22B facing away the die pad 10 (that is, with the base lead portion 22A facing the semiconductor die 14), as described in the following with reference to Figure 3.

It is noted that the leadframe 21 illustrated in Figure 1 may be a portion of a leadframe reel or panel comprising a plurality of such leadframes held together via sacrificial connecting bars running at the periphery of the (individual) leadframes 21. In fact, in current manufacturing processes of semiconductor devices, plural devices are manufactured concurrently to be separated into individual devices in a final singulation. For simplicity and ease of explanation, the following description will refer to manufacturing a single device.

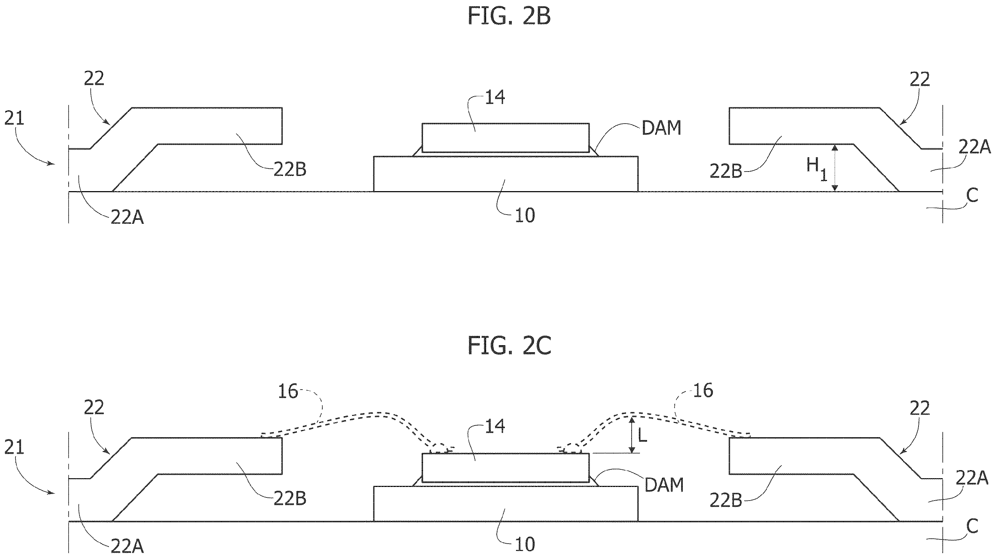

Figure 2B is illustrative of a (power) semiconductor (Si, SiC or GaN, for instance) die 14 arranged at the top/front surface of the die pad 10. As illustrated, this may be via attach material DAM such as a die-attach glue, for instance.

Figure 2C is illustrative of a wire bonding step where electrically conductive wires 16 are provided to electrically couple the semiconductor die 14 arranged at the die pad 10 and selected low-power leads 12 (that is, in the second set of leads) in the array of electrically conductive leads.

The electrically conductive wires 16 extend between the semiconductor die 14 and (low-power) leads 12 arranged adjacently to the (high-power) leads 22 visible in the figures; this is highlighted in the figures by illustrating the electrically conductive wires 16 with dashed lines.

As illustrated, electrically conductive wires 16 may be provided with a loop heigh L at the semiconductor die 14.

As known to those skilled in the art, providing a wire 16 as illustrated in Figure 2C may involve:
forming a first bond at the top/front surface of the semiconductor die 14 arranged at the die pad 10,
extending the wire 16 from the semiconductor die 14 to the proximal portion of a lead 12 with a desired wire loop L,
forming a second bond at the lead 12.

Providing electrically conductive wires 16 as described in the foregoing - oftentimes referred to as direct bonding - may be done via a per se conventional wire bonding apparatus, which makes it unnecessary to provide a more detailed description herein.

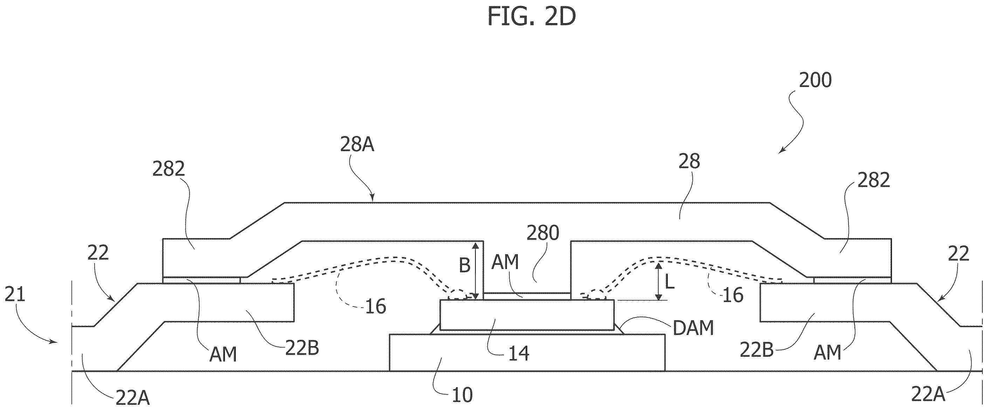

Figure 2D is illustrative of an electrically conductive clip 28 according to embodiments of the present description applied onto the semiconductor die 14 to provide electrical coupling between the semiconductor die 14 and at least one (high-power) lead 22 in the first set of leads 22.

As illustrated, an electrically conductive clip 28 comprises a body (a substantially flat body, for instance, as visible also in the plan views of Figures 4 to 6 discussed in the following) and a pillar-like base portion or protrusion 280 protruding from a surface (the bottom surface in the figures) of the body.

The electrically conductive clip 28 may be sized and dimensioned so that the electrically conductive wires 16 provided between the semiconductor die 14 and the leads 12 in the second set of leads extend below the body of the electrically conductive clip 28, along paths that do not interfere with the electrically conductive clip 28.

To that effect, the protrusion 280 of the clip 28 may be formed with a height B larger than the loop L of the wires 16, for instance.

In embodiments as illustrated in Figure 2D (and Figure 2E) the electrically conductive clip 28 comprises distal portions 282 that bend towards the raised portion 22B of the leads 22. Such a bending of the distal portions 282 may facilitate electrically contacting the leads and, at the same time, providing enough room for the electrically conductive wires 16 to extend below the electrically conductive clip 28.

An electrically conductive clip 28 as described in the foregoing may be provided via stamping or punching of a metallic sheet (of copper, for instance).

As illustrated, the electrically conductive clip 28 is applied onto the semiconductor die 14 with the protrusion (or base portion) 280 of the clip 28 in (electrical) contact with the top/front surface of the semiconductor die 14. Attach material AM such as solder paste or an electrically conductive glue may be provided at the top/front surface of the semiconductor die 14 to facilitate forming the electrical coupling between the clip 28 and semiconductor die 14 at die bonding pads provided at the top/front surface of the semiconductor die 14 (the die bonding pads at the top/front surface of the semiconductor die 14 are not visible in the figures for scale reasons).

One or more distal portions 282 of the clip 28 are in electrical contact with the (high-power) leads 22 at the raised lead portion 22B thereof; attach material AM may be provided also at the top/front surface of the raised lead portion 22B to facilitate electrical coupling between the lead 22 and the clip 28.

Figure 2E is illustrative of an electrically insulating encapsulation 20 molded onto the assembly in order to provide a protective plastic package to the device 200.

The encapsulation 20 is formed by molding an electrically insulating molding compound (an epoxy resin, for instance) onto the assembly; a (per se known) curing step may follow the molding step.

As illustrated, the top/front surface 28A of the electrically conductive clip 28 is left exposed at the top/front surface of the electrically insulating encapsulation 20, that is, a surface 28A of the electrically conductive clip 28 is left uncovered by the molding compound forming the electrically insulating encapsulation 20.

Leaving the top/front surface 28A of the clip 28 exposed at the surface of the encapsulation 20 may involve a back grinding step and/or a film-assisted molding step (processing steps per se conventional in the art).

In summary, processing steps as described in relation to Figures 2A to 2E comprise arranging a semiconductor die 14 at a die pad 10 of a leadframe 21. The leadframe 21 comprises an array of electrically conductive leads 12, 22 around the die pad 10. The array of electrically conductive leads 12, 22 includes a first set of electrically conductive leads (high-power leads 22, for instance) and a second set of electrically conductive leads (low-power leads 12, for instance). At least one electrically conductive lead 22 in the first set of electrically conductive leads 22 comprises a base lead portion 22A co-planar with the die-pad 10 and a raised lead portion 22B, wherein the die pad 10 is arranged at a downset location with respect to said raised lead portion 22B.

The semiconductor die 14 is electrically coupled to leads 12 in the second set of electrically conductive leads 12 via electrically conductive wires 16 extending therebetween.

Subsequently, the semiconductor die 14 is electrically coupled to the at least one electrically conductive lead 22 in the first set of electrically conductive leads 22 by applying onto the semiconductor die 14 and the electrically conductive wires 16 coupling the semiconductor die 14 to the leads 12 in the second set of electrically conductive leads 12 an electrically conductive clip 28. The electrically conductive clip 28 comprises an electrically conductive protrusion 280 electrically coupled to the semiconductor die 14 as well as at least one distal portion 282 electrically coupled to the raised lead portion 22B of the least one conductive lead 22 in the first set of electrically conductive leads 22.

The electrically conductive wires 16 provided between the semiconductor die 14 and the at least one lead 22 in the first set of leads 22 may extend below the electrically conductive clip 28, that is, between a first plane defined by the die pad 10 (or defined by the base lead portion 22A of the at least one lead 22) and a second plane defined by the body of the electrically conductive clip 28 applied onto the semiconductor die 14.

An electrically insulating encapsulation 20 may be molded onto the semiconductor die 14 having the electrically conductive clip 28 applied thereon, the electrically insulating encapsulation 20 having a surface opposite the die pad 10. A surface 28A of the electrically conductive clip 28 applied onto the semiconductor die 14 and the electrically conductive wires 16 electrically coupling the semiconductor die 14 is exposed at said surface of the electrically insulating encapsulation 20.

As illustrated in the figures, the electrically insulating encapsulation 20 leaves exposed (at the bottom surface) the die pad 10 and the base lead portion 22A (co-planar with the die pad 10) of the at least one conductive lead in the first set of electrically conductive leads 22.

Solutions as described in the foregoing thus facilitate providing a semiconductor device wherein:
an electrically conductive clip 28 has a surface 28A thereof exposed at a (top/front) surface of the electrically insulating encapsulation 20 of the device 200, and
electrically conductive wires 16 are provided (for low-power electrical coupling, for instance) below the clip 28, along non-interfering paths with the electrically conductive clip 28.

Having the surface 28A of the electrically (and thermally) conductive clip 28 exposed at the (top/front) surface of the encapsulation 20 of the device 200 facilitates dissipating the heat that may generate during normal operation of the device 200. Moreover, electrically conductive wires 16 may be provided for low-power electrical coupling without affecting the size of the exposed surface 28A of the electrically conductive clip 28.

Figure 3 is illustrative of a device 200 according to further embodiments of the present description. As illustrated, the device 200 comprises electrically conductive leads 22 in the first set of leads that are arranged with the base lead portion 22A facing the die pad 10 (and the raised lead portion 22B facing away therefrom).

The processing steps to obtain a device 200 as illustrated in Figure 3 are similar to the processing steps described in relation to Figures 2A to 2E and a similar description is not repeated for brevity.

Advantageously, the electrically conductive wires 16 electrically coupling the semiconductor die 14 to the (low power) leads 12 may be provided via reverse bonding.

That is, providing the electrically conducting wires 16 may involve, for each wire 16:
forming a first bond at the lead 12,
extending the electrically conductive wire from the first bond at the lead 12 to the semiconductor die 14, and
forming a second bond at the semiconductor die 14 (at die bonding pads provided at the top/front surface of the semiconductor die 14).

Reverse bonding may be advantageous in so far as it facilitates providing (electrically conductive) wires 16 with a lower loop at the semiconductor die 14.

As illustrated in Figure 3, the distal portions 282 of the electrically conductive clip 28 electrically contacting the raised portion 22B of the lead 22 may have a surface exposed at the top/front surface of the electrically insulating encapsulation, thus further facilitating dissipation of heat generated during operation of the device 200.

Figures 4 to 6 are plan views illustrative of aspects of semiconductor devices 200 (as seen from the viewing direction indicated by the arrows I and II of Figures 2E and 3, respectively) according to embodiments of the present description.

In these figures, half of the electrically conductive clip 28 (the half on the right-hand side in the figures) is illustrated as "transparent" in order to illustrate the structure of the device 200 below the electrically conductive clip 28.

As illustrated in Figures 4 and 5, the electrically conductive clip 28 may comprise distal portions 282 protruding from the body of the clip 28 (as exemplified in Figure 4) or distal portions 282 having the same width of the body of the clip 28 (as exemplified in Figure 5).

It is noted that in these embodiments the distal portions 282 of the clips may be exposed at the (top/front) surface of the electrically insulating encapsulation 20 (as exemplified in Figure 3, for instance) or may bend towards the leads 22 (as exemplified in Figure 2E, for instance).

As illustrated in Figures 4 and 5, low-power leads 12 and high-power leads 22 may be arranged on different sides of the leadframe 21.

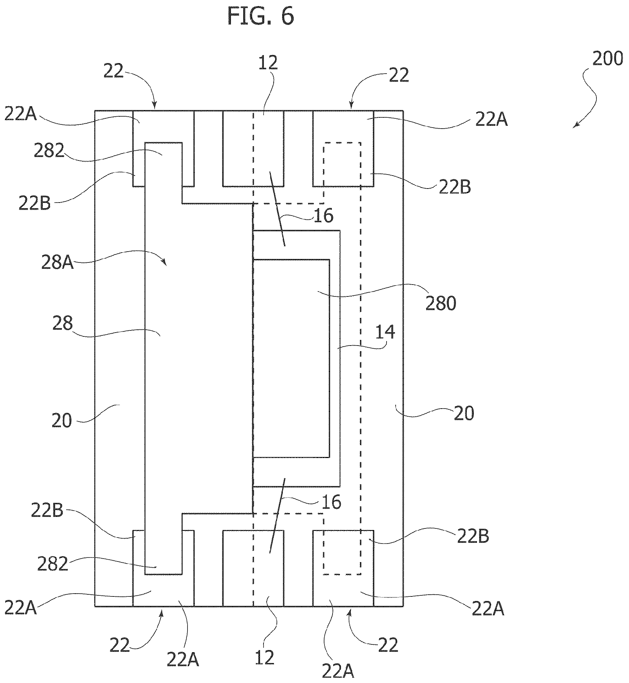

In embodiments as exemplified in Figure 6 the leadframe 21 of the device 200 comprises low-power leads 12 and high-power leads 22 arranged adjacently to each other, on a same side of the leadframe 21.

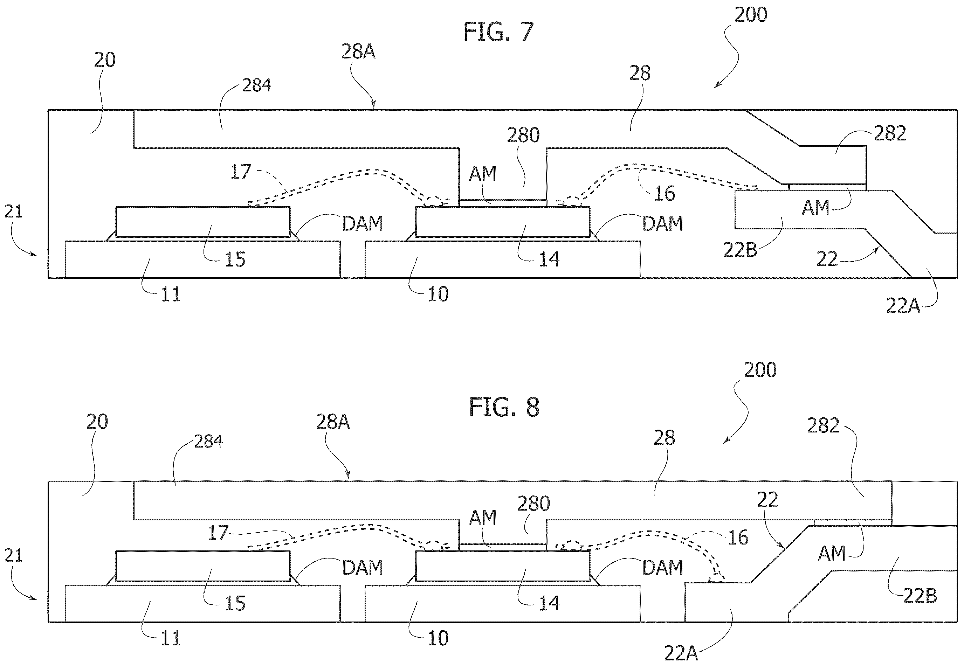

Figures 6 and 7 are illustrative of embodiments of the present description wherein a device 200 comprises two (or more) semiconductor dice 14, 15.

That is, a further semiconductor die 15 (a controller die, for instance) may be arranged (via die-attach material DAM) at a corresponding further die pad 15 in the leadframe 21. It is noted that instead of being distinct elements as illustrated in the figures, the two die pads 10, 11 may be joined to form a single die pad having two dice mounted at respective die mounting locations of the (single) die pad.

Electrically conductive wires 16 are provided to electrically couple the semiconductor die 14 to low-power leads 12 and further electrically conductive wires 17 are provided to electrically couple the semiconductor die 14 to the further semiconductor die 15.

An electrically conductive clip 28 having a protrusion or base portion 280 is applied onto the semiconductor dice 14, 15 and onto the electrically conductive wires 16 as well as onto the further electrically conductive wire 17.

As illustrated, the electrically conductive clip 28 is applied with the protrusion 280 in electrical contact with the (first, power) semiconductor die 14 and the distal portion(s) in electrical contact with (one or more) lead(s) 22 in the first set of electrically conductive leads.

Advantageously, the further electrically conductive wires 17 electrically coupling the semiconductor die 14 to the further semiconductor die 15 may extend below the electrically conductive clip 28, that is, between the body of the clip 28 and a plane defined by the die pads 14, 15.

A device 200 comprising a further semiconductor die 15 as illustrated may be provided with the raised portion 22B of the at least one lead 22 in the first set of electrically conductive leads 22 facing the die pad 10 (as illustrated in Figure 7) or facing away the die pad 10 (as illustrated in Figure 8).

In devices 200 as exemplified in Figure 7 and 8 the distal portion(s) 282 may bend towards the raised portion 22B of the lead 22 (as illustrated in Figure 7) or may have a surface exposed at the top/front surface of the electrically insulating encapsulation 20 (as illustrated in Figure 8).

Advantageously, the other distal portion(s) 284 of the electrically conductive clip 28 (that is, the distal portion 284 on the left-hand side of the figures) may extend above the further semiconductor die 15 and may have a surface exposed at the top/front surface of the electrically insulating encapsulation 20, thus further improving dissipation of heat generated by the device 200.

Without prejudice to the underlying principles, the details and the embodiments may vary, even significantly, with respect to what has been described by way of example only without departing from the scope of the embodiments.

The extent of protection is determined by the annexed claims.

## Claims

1. A method, comprising:
arranging a semiconductor die (14) at a die pad (10) of a leadframe (21), wherein the leadframe (21) comprises an array of electrically conductive leads (12, 22) around the die pad (10), the array including a first set of electrically conductive leads (22) and a second set of electrically conductive leads (12), wherein at least one conductive lead in the first set of electrically conductive leads (22) comprises a base lead portion (22A) co-planar with the die-pad (10) and a raised lead portion (22B), wherein the die pad (10) is arranged at a downset location with respect to said raised lead portion (22B),
electrically coupling the semiconductor die (14) to leads (12) in the second set of electrically conductive leads (12) via electrically conductive wires (16) extending therebetween,
electrically coupling the semiconductor die (14) to said at least one conductive lead (22) in the first set of electrically conductive leads (22) by applying onto the semiconductor die (14) and said electrically conductive wires (16) electrically coupling the semiconductor die (14) to said leads (12) in the second set of electrically conductive leads (12) an electrically conductive clip (28) comprising an electrically conductive protrusion (280) electrically coupled to the semiconductor die (14) as well as at least one distal portion (282) electrically coupled to the raised lead portion (22B) of said at least one conductive lead (22) in the first set of electrically conductive leads (22), and
molding an electrically insulating encapsulation (20) onto the semiconductor die (14) having the electrically conductive clip (28) applied thereon, the electrically insulating encapsulation (20) having a surface opposite the die pad (10), wherein the electrically insulating encapsulation (20) encapsulates the semiconductor die (14) and said electrically conductive wires (16) and wherein a surface (28A) of the electrically conductive clip (28) applied onto the semiconductor die (14) and said electrically conductive wires (16) is exposed at said surface of the electrically insulating encapsulation (20), and wherein the electrically insulating encapsulation (20) leaves exposed the die pad (10) and said base lead portion (22A) of the at least one conductive lead in the first set of electrically conductive leads (22).

2. The method of claim 1, wherein said at least one conductive lead (22) in the first set of electrically conductive leads (22) comprises a raised lead portion (22B) arranged proximally of the die pad (10).

3. The method of claim 2, wherein electrically coupling the semiconductor die (14) to leads (12) in the second set of electrically conductive leads (12) via electrically conductive wires (16) comprises:
forming a first bond at the semiconductor die (14),
extending an electrically conductive wire (16) from the semiconductor die (14) to a lead (12) in the second set of electrically conductive leads (12), and
forming a second bond at the lead (12) in the second set of electrically conductive leads (12).

4. The method of claim 1, wherein said at least one conductive lead (22) in the first set of electrically conductive leads (22) comprises a base lead portion (22A) arranged proximally of the die pad (10).

5. The method of claim 4, wherein electrically coupling the semiconductor die (14) to leads (12) in the second set of electrically conductive leads (12) via electrically conductive wires (16) comprises:
forming a first bond at a lead (12) in the second set of electrically conductive leads (12),
extending the electrically conductive wire (16) from the lead (12) in the second set of electrically conductive leads (12) to the semiconductor die (14), and
forming a second bond at the semiconductor die (14).

6. The method of any of the previous claims, comprising:
arranging a second semiconductor die (15) at a second die pad (11) of the leadframe (21),
electrically coupling the semiconductor die (14) to the second semiconductor die (15) via further electrically conductive wires (17) extending therebetween, and
electrically coupling the semiconductor die (14) to said at least one conductive lead (22) in the first set of electrically conductive leads (22) by applying onto the semiconductor die (14), said electrically conductive wires (16) and said further electrically conductive wires (17) the electrically conductive clip (28).

7. A device (200), comprising:
a semiconductor die (14) arranged at a die pad (10) of a leadframe (21), wherein the leadframe (21) comprises an array of electrically conductive leads (12, 22) around the die pad (10), the array including a first set of electrically conductive leads (22) and a second set of electrically conductive leads (12), wherein at least one conductive lead in the first set of electrically conductive leads (22) comprises a base lead portion (22A) co-planar with the die-pad (10) and a raised lead portion (22B), wherein the die pad (10) is arranged at a downset location with respect to said raised lead portion (22B),
electrically conductive wires (16) extending between the semiconductor die (14) and leads (12) in the second set of electrically conductive leads (12) providing electrical coupling therebetween,
an electrically conductive clip (28) applied onto the semiconductor die (14) and said electrically conductive wires (16) electrically coupling the semiconductor die (14) to said leads (12) in the second set of electrically conductive leads (12) to provide electrical coupling between the semiconductor die (14) and said at least one conductive lead (22) in the first set of electrically conductive leads (22), wherein the electrically conductive clip (28) comprises an electrically conductive protrusion (280) electrically coupled to the semiconductor die (14) as well as at least one distal portion (282) electrically coupled to the raised lead portion (22B) of said at least one conductive lead (22) in the first set of electrically conductive leads (22), and
an electrically insulating encapsulation (20) molded onto the semiconductor die (14) having the electrically conductive clip (28) applied thereon, the electrically insulating encapsulation (20) having a surface opposite the die pad (10), wherein the electrically insulating encapsulation (20) encapsulates the semiconductor die (14) and said electrically conductive wires (16) and wherein a surface (28A) of the electrically conductive clip (28) applied onto the semiconductor die (14) and said electrically conductive wires (16) is exposed at said surface of the electrically insulating encapsulation (20), and wherein the electrically insulating encapsulation (20) leaves exposed the die pad (10) and said base lead portion (22A) of the at least one conductive lead in the first set of electrically conductive leads (22).

8. The device (200) of claim 7, wherein said at least one conductive lead (22) in the first set of electrically conductive leads (22) comprises:
a raised lead portion (22B) arranged proximally of the die pad (10), or
a base lead portion (22A) arranged proximally of the die pad (10).

9. The device (200) of claim 7 or claim 8, comprising:
a second semiconductor die (15) arranged at a second die pad (11) of the leadframe (21),
further electrically conductive wires (17) extending between the semiconductor die (14) to the second semiconductor die (15) providing electrically coupling therebetween, and
the electrically conductive clip (28) applied onto the semiconductor die (14), said electrically conductive wires (16) and said further electrically conductive wires (17).
